## Europäisches Patentamt
## European Patent Office
## Office européen des brevets

(11) Publication number: **0 146 339**
**B1**

(12) **EUROPEAN PATENT SPECIFICATION**

(45) Date of publication of patent specification: **13.09.89**

(51) Int. Cl.⁴: **H 01 Q 1/44, H 01 Q 1/32**

(21) Application number: **84308648.9**

(22) Date of filing: **12.12.84**

�54 Electrical signal separating device having isolating and matching circuitry.

(30) Priority: **20.12.83 US 563513**
**25.02.84 GB 8404982**

(43) Date of publication of application:
**26.06.85 Bulletin 85/26**

(45) Publication of the grant of the patent:
**13.09.89 Bulletin 89/37**

(84) Designated Contracting States:
**AT BE CH DE FR GB IT LI LU NL SE**

(56) References cited:
**DE-A-2 360 672**
**DE-A-2 635 217**
**DE-A-2 639 947**
**DE-B-2 413 712**
**DE-B-2 825 812**
**FR-A-2 332 679**
**GB-A-2 019 100**
**US-A-3 484 584**
**US-A-3 623 108**
**US-A-4 085 405**
**US-A-4 086 594**
**US-A-4 141 016**
**US-A-4 422 077**

(73) Proprietor: **BSH ELECTRONICS LIMITED**
**Scottish Provident House 52 Brown Street**
**Manchester M2 2LD (GB)**

(72) Inventor: **Kropielnicki, Jerzy Jacek**
**40 Glebelands Road**
**Knutsford, Cheshire (GB)**
Inventor: **Last, James David**
**Orchard House Gorddinog, Llanfairfechan**
**Gwynedd, North Wales (GB)**
Inventor: **Easter, Brian**
**Slieve Donard Talwrn Road, Llangefni**
**Gwynedd, North Wales (GB)**

(74) Representative: **Quest, Barry et al**
**M'CAW & Co. 41-51 Royal Exchange Cross**
**Street**
**Manchester M2 7BD (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

### Background of the invention

This invention relates to the field of electrical signal separating devices. or isolating and matching devices which are utilised to enable a heating element means of an electrically heatable window i.e., a motor vehicle heated rear window (defroster) unit not designed specifically to be an antenna or aerial to be used as an efficient radio frequency transmitting or receiving aerial, while permitting the window unit to be used simultaneously (if so desired) for a heating (demisting) purpose.

Kropielnicki U.S. Patents 4,086,594 discloses a device in the field of the present invention and provides an electrical signal separating device for separating a radio signal from the heating current of an electrically heated window, and includes the usage of an isolating or blocking circuit which comprises two mutually coupled coils arranged so as to provide high impedance paths for in-phase fluctuating currents but low resistance paths for currents flowing. from a motor vehicle d.c. power supply, whereby the mutually coupled coil arrangement effectively blocks the radio frequency signals while passing the current from the d.c. power supply to the heating element, such referenced device being used to enable a heated rear window of a motor vehicle to be used as a radio aerial and for heating purposes.

Another device in the field of the present invention is Kropielnicki U.S. Patent No. 4,422,077 the disclosure of which provides an improvement of the above-referenced prior Kropielnicki U.S. Patent.

Such improvement relates to enabling the use of a motor vehicle electrically heated window as a transmitting or receiving aerial at AM or VHF/FM wavelengths, and includes matching and tuning circuitry being operative to effectively match the impedance of the window heating element to an aerial feeder circuit of a transmitter so that efficient VHF transmission, from the motor vehicle electrically heated window of signals received at an aerial input terminal, is effected; this disclosed improvement further incorporating, in combination, isolating circuitry comprising mutually coupled coils.

The present invention provides further advantageous and improved embodiments in this field of invention and further provides specific improvements of the devices disclosed in the above-referenced U.S. Patents.

### Brief description of the invention

In accordance with the present invention therefore there is provided an isolating and matching device to enable a heating element of a motor vehicle electrically heatable window, not designed specifically to be an aerial to be used as a receiving aerial in a band within the VHF range, said device having input leads for connection to a motor vehicle d.c. power supply, output leads for connection to said heating element, an aerial terminal for connection to an aerial feeder circuit of a receiver, isolating circuitry coupled with said input and output leads and operable to permit passage of d.c. power from said input leads to said output leads while isolating or blocking passage of RF signals from said output leads to said input leads, and aerial matching circuitry interposed between said output leads and said aerial terminal, characterised in that said matching circuitry has components arranged to be connected to said heating element so as to define therewith a circuit which is resonant near the centre of a band within the VHF range, and which is operable to effectively match the impedance of said resonance circuit to an input impedance of the aerial feeder.

In one embodiment of the invention, which is a Series VHF Matching embodiment, the said matching circuitry is operable to bring the heating element to series resonance near the centre of the VHF band; that is, the motor vehicle electrically heatable window forms together with said components a series resonance in the VHF band and becomes usable as an efficient VHF receiving aerial. The matching circuitry also comprises a parallel resonant circuit directly coupled with said components to form therewith near-optimum matching.

With a second embodiment of the invention, which is a Shunt VHF Matching embodiment, said matching circuitry includes an inductance of the isolating circuitry arranged to bring the heating element to resonance near the centre of the VHF band; that is, the motor vehicle electrically heatable window forms together with said components a parallel resonance in the VHF band and becomes usable as an efficient VHF receiving aerial. The matching circuitry also comprises a parallel resonant circuit operable with said components to give a VHF broad-band matching characteristic.

With a third embodiment of the invention, which is a Split Passband Matching embodiment, said matching circuitry is arranged for providing two VHF passbands, one centred on a predetermined VHF transmit frequency and the other centered on a predetermined VHF receive frequency; whereby, the motor vehicle electrically heatable window becomes usable as an efficient VHF transmitting and/or receiving aerial. In this embodiment, the isolating circuit is arranged to bring the heating element to parallel resonance near the centre of the VHF band, a first series resonator is provided to produce a series resonance near the centre of the VHF band, a second series resonator is provided to produce a second series resonance near the centre of the VHF band, and the matching circuitry is arranged for providing two VHF passbands and further includes two series resonant circuits, one being series resonant at a predetermined VHF transmit frequency and the other being series resonant at a predetermined VHF receive frequency, such two series resonant circuits being connected in parallel with each other and connected between the beforementioned second series resonator and the aerial feeder circuit of the transmitter/receiver.

With respect to the above-described embodiments, a more full and clear explanation will be had by reference to the hereinbelow described drawings of the invention and the following detailed description of the drawings.

Brief description of the drawings

Figure 1 shows a simplified block diagram of the Series VHF Matching embodiment;

Figure 2 depicts a detailed schematic diagram of the Series VHF Matching embodiment shown in Figure 1 in block diagram form;

Figure 3 shows a simplified block diagram of the Shunt VHF Matching embodiment;

Figure 4 depicts a detailed schematic diagram of the Shunt VHF Matching embodiment shown in Figure 3 in block diagram form;

Figure 5 is a block diagram of the Split Passband Matching embodiment; and

Figure 6 shows a modified isolating circuit inductor.

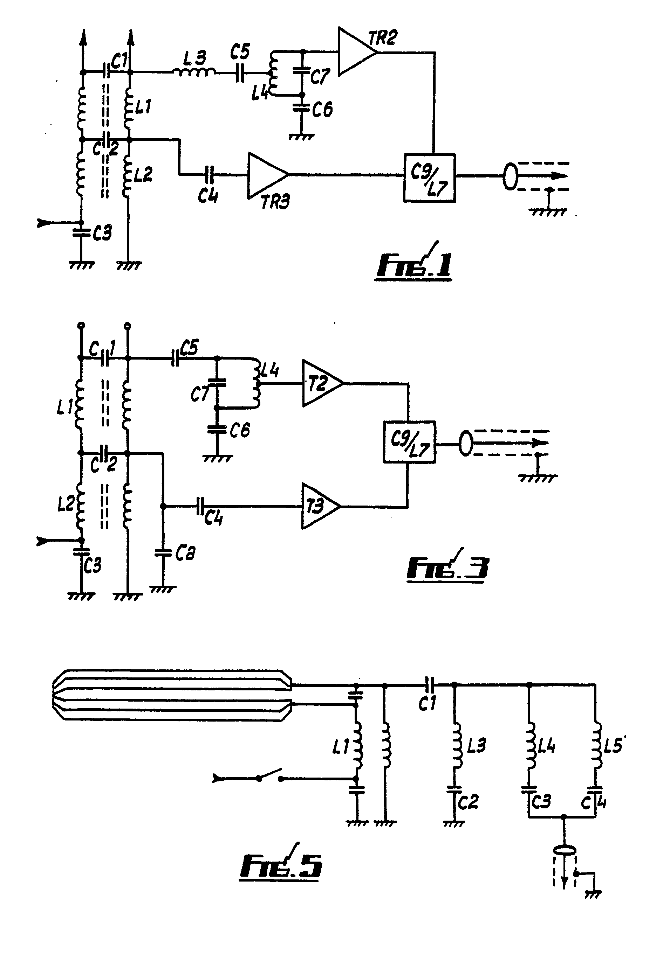

Referring first to Figure 1, there is illustrated therein a Series VHF Matching embodiment of the present invention.

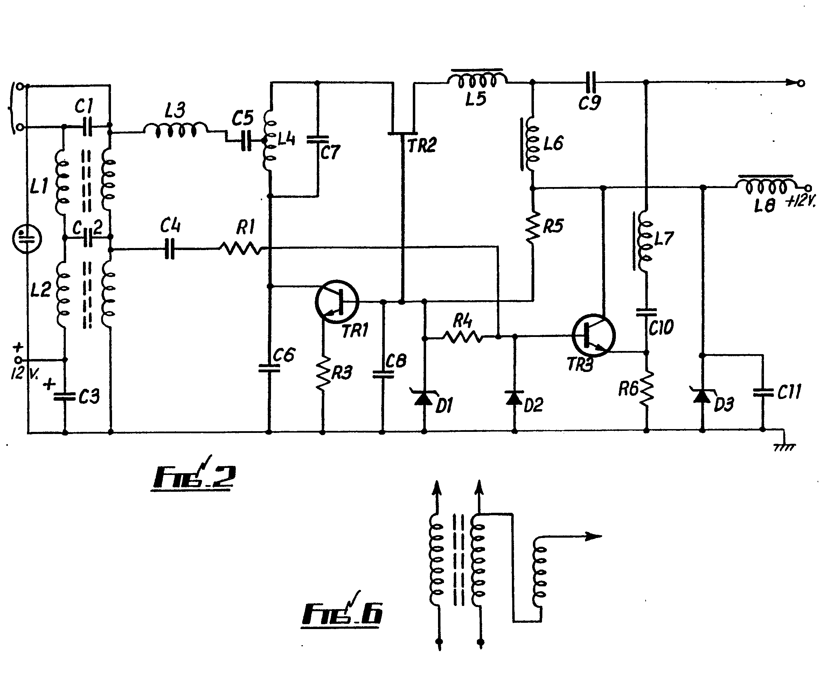

For the sake of convenience, the operation of the device depicted in Figures 1 and 2 will be described hereinafter in four sections.

Signal frequency input and matching circuit

A motor vehicle electrically heated window and its heating element (not shown) are isolated from a motor vehicle D.C. power supply means, connectable at the top of C3, at signal frequencies of interest by two bi-filar coil circuit means L1 and L2, which may be bifilar chokes. L1 has a ferrite rod core and is substantially or approximately self-resonant in the VHF range, while L2 comprises a ferrite pot core and provides a high impedance at frequencies in the AM band. Capacitor C3 provides further decoupling of the depicted heater supply line connected at the top of the same. Capacitors C1 and C2 effectively couple the depicted two paths to the terminal leads of a window heater element in parallel at signal frequencies. Components L3, C5, together with the leakage inductance of a tapped coil L4, are arranged to bring the electrically heatable window and/or its heating element to series resonance near the center of the VHF band. This series resonant characteristic, together with a parallel-resonant circuit L4—C7, form a near-optimum matching circuit which couples the terminal leads of the heating element to the input of a VHF amplifier circuit means designated TR2. Component C5, connected in series between L3 and tapped coil L4 has a compromise value and operates to effectively block AM signals from the VHF amplifier input and, in this regard, a small value is desired to reduce the capacitance loading of the depicted AM amplifier input, but an excessively low value would increase the reactance slope of the series resonance at VHF and reduce the obtainable bandwidth and performance. The impedance characteristic of L1 is such that VHF signals are effectively blocked, but AM signals are freely passed and are coupled to AM amplifier means TR3 by capacitor C4.

VHF amplifier

Junction FET TR2 operates in a grounded-gate circuit at signal frequency, bypassing being provided by capacitor C8. The source of TR2 is directly coupled to the aforementioned input matching circuit, i.e., as shown, in Figure 2, to the junction of L4—C7. The drain is coupled to the RF output circuit line having an aerial terminal (not shown) for connection to an aerial feeder circuit of a radio receiver, by inductor L5, which resonates with the drain capacitance, together with strays, near VHF band-center and provides near optimum matching between the impedance of the cable feeding and connected to a radio receiver and the drain of FET TR2, an exemplary impedance being 100Ω. Capacitor C9 blocks the amplifier supply voltage at the drain from the RF signal output line, the amplifier supply voltage being connected to the circuit at the depicted +12 V point at the right-hand side of L8.

AM band amplifier

Bi-polar transistor TR3 acts as an emitter-follower stage, its base being connected to AM input coupling capacitor C4 via resistor R1 while its output is coupled from its emitter to the RF output line connection to a radio receiver via blocking capacitor C10 and ferrite inductor or choke L7. L7 is self-resonant in the VHF range and effectively prevents the low output impedance of AM amplifier TR3 from loading the output of VHF amplifier TR2. The reactance of VHF output capacitor C9 is sufficiently high in the AM range to block AM signals from entering the VHF amplifier drain supply. Resistor R1 serves to prevent high frequency parasitic oscillations in the AM amplifier circuit and R1 could be replaced by two separate resistors connected in series with each other for convenience in a printed circuit board layout of this circuit, the values of such series connected resistors being 47 Ω each.

Bias-supply circuits

In order to reduce the sensitivity of the operating parameters of the unit depicted in Figures 1 and 2, to supply voltage variations and to FET parameter variations, the section of this circuit centred on zener diode D1 and transistor TR1, together with associated resistors R5 and R3, act to provide a stable bias-supply voltage which is connected to the gate of TR2 and to the base of TR3, via R4, with a current source being connected to the source of TR2. Negligible variations of the operating parameters of the depicted amplifier circuits occur within the normal range of supply voltage variations experienced in a motor vehicle. Noise and interference possibly occurring with the power supply voltage, supplied at the depicted point from a motor vehicle d.c. power supply or other appropriate source, is rejected by filter components L8, which is a ferrite inductor, and C11. Zener doide D3 provides protection from possible large voltage transients and reverse polarity connections on the supply voltage. Further with respect to filter components L8 and C11, the produced filtered supply voltage therefrom is connected directly to the collector of AM amplifier TR3 and, via VHF ferrite inductor or choke L6, to the drain of TR2. Two further protective devices are incorporated in the circuit embodiment of Figure 2, namely, a neon tube element and diode D2, which are connected as shown in order to give protection in the event of static discharge occurring at the heater element of a motor vehicle electrically heatable window unit during any individual or simultaneous operation or function thereof.

With respect to the above-described isolating circuit means of this embodiment, this includes mutually coupled coils which may comprise a bifilar winding, a toroidal or U-shaped core wound with two identical mutually coupled coils. Other modifications and variations of the depicted isolating circuitry may now become apparent to those skilled in the art and, for example, a mutually coupled coil circuit means could be substituted for bifilar component L2 in a closed magnetic circuit form.

Accordingly, the embodiment depicted in Figures 1 and 2 enables a heating element of a motor vehicle electrically heatable window, not designed specifically to be an antenna or aerial and essentially aperiodic and non-resonant at RF frequencies, to become usable as an efficient VHF receiving aerial, and to afford reception of AM signals by an appropriate receiver.

L1 and L2 are depicted as ferrite-cored bifilar coil arrangements, one having a ferrite rod core and the other having a ferrite pot core, as set forth above.

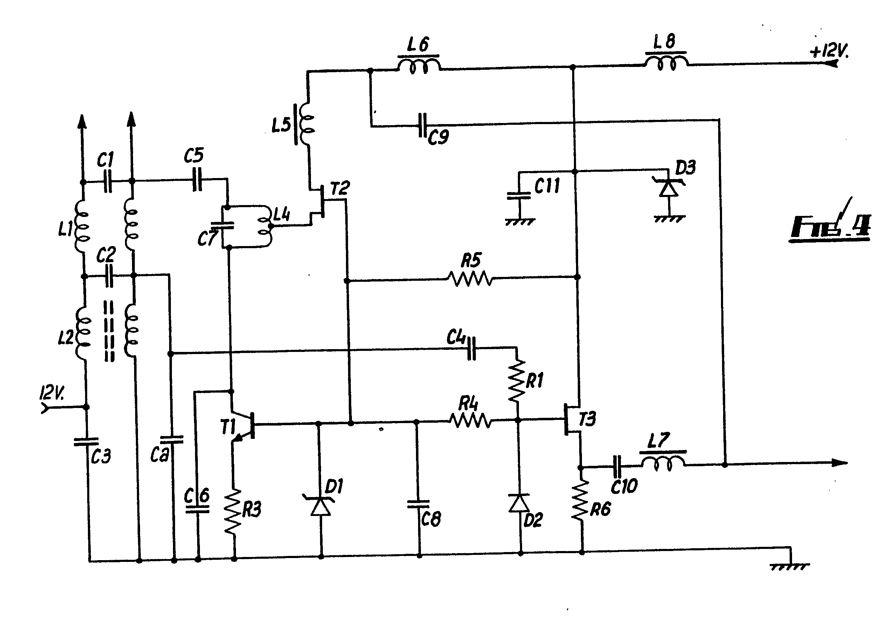

Referring now to Figures 3 and 4, a Shunt VHF Matching embodiment is shown therein. A most significant aspect of the Shunt Matching embodiment, as compared to the Series Matching embodiment depicted in Figures 1 and 2, is the modified form of the VHF matching circuitry and its connection to and with the isolating circuitry. Depending on the dimensions and detailed arrangement of a motor vehicle electrically heatable window unit, and on the frequency range of a desired VHF band of interest, it may be more convenient to operate a motor vehicle electrically heatable window unit, used as an antenna, as a parallel resonant circuit when incorporating it in the overall matching circuit. In this regard, bifilar inductor L1 is arranged in parallel with the window heater via its terminal leads to achieve resonance in the center of the VHF band.

For the sake of convenience, the operation of the device depicted in Figures 3 and 4 will be described hereinafter in four sections.

Signal frequency input and matching circuit

Depending on the dimensions and detailed arrangement of a motor vehicle electrically heated window unit and its convenience in relation to the pattern of the heater element, i.e., the size, shape, and position of the window unit and its heating element on a specific vehicle, it is, as stated above, more convenient to operate the window unit as a parallel resonant circuit. To this end, the inductance of bifilar coil means L1, together with the reactance of 68 pF capacitor $C_a$, are arranged and connected with each other and the window heater unit to bring the same to resonance near the center of the VHF band. Capacitor $C_a$ is a compromise in its value design since too small a value will result in increase susceptance slope and loss of bandwidth/performance in the VHF band; and, a large value for this capacitor will jeopardize AM performance. For the sake of explanation, it may be stated that the above-described operation of L1 and $C_a$ produce a parallel resonance near VHF band center, which is formed at the heater· terminal lead connections. This parallel resonance is coupled by capacitor C5 to a second parallel resonance circuit means L4—C7 in such a way that a broadband matching characteristic is formed. The actual values of the beforementioned components L1, L4, C5 and C7 and $C_a$ may vary depending upon the vehicle model and/or the shape and size of the electrically heatable window unit.

VHF amplifier

Junction FET T2 operates in a grounded-gate circuit at signal frequency, bypassing of the same being provided by capacitor C8. The source of T2 is directly coupled to the beforementioned components of the matching circuitry and, in particular, to tapped coil L4. The drain of T2 is coupled to the RF output circuit line, which includes an aerial terminal (not shown), by ferrite inductor L5, which resonates with the drain capacitance, together with strays, near VHF band-center and effectively provides near optimum matching between the impedance of the cable feeding a radio receiver, or the impedance of an aerial feeder circuit of the same, which could be approximately 100 Ω, and the drain of T2. Capacitor C9 blocks the amplifier supply voltage at the drain side of T2 from the RF signal output circuit line, such amplifier supply voltage being inputted as shown n Figure 4 at a 12 volt connection point to the right-side of L8.

AM band amplifier

FET T3 acts as a source follower stage, its gate being connected to input coupling capacitor C4 via resistor R1, while its output, drain side, is coupled from its source to the RF output connector line via a blocking capacitor C10 and a ferrite inductor L7; L7 is self-resonant in the VHF range and effectively prevents the low output impedance of AM amplifier means T3 from loading the output of VHF amplifier means T2. The reactance of VHF output capacitor C9 is sufficiently high in the low frequency AM range to block AM signals from entering the VHF amplifier T2 drain supply. Resistor R1 serves to prevent the occurrence of high frequency parasitic oscillations in the AM amplifier circuit of T3.

Bias-supply circuits

In order to reduce the sensitivity of the operating parameters of the depicted embodiment to supply voltage variations and to FET parameter variations, the section of the circuit centred on zener diode D1 and bi-polar transistor T1, together with associated resistors R3 and R5, act to provide a stable bias voltage supply, which is connected to the gates of T2 and T3, with a current source being connected to the source of T2, as shown in Figure 4. Negligible variations of the operating parameters of the depicted amplifier circuits occur within the normal range of supply voltage variations experienced in a motor vehicle. Noise and interference on the motor vehicle d.c. power supply, or an equivalent amplifier supply voltage means, is rejected by filter components L8 and C11. Zener diode D3 provides protection from possible large voltage transients and reverse polarity connections on the amplifier supply voltage. The filtered amplifier supply voltage is connected, as shown, to AM amplifier FET T3, and via VHF ferrite inductor or choke L6, to the drain D of VHF amplifier T2. A further protective device is incorporated, this being diode D2 to give protection in the event of a static discharge occurring at or within the electrically heated window unit and its heating element, during the operation of the same.

Variations and modifications of the Shunt Matching embodiment will now become apparent to those skilled in the art and, in this regard, the isolating circuitry could include mutually coupled coils which may comprise a bifilar winding, a toroidal or U-shaped core wound with two identical mutually coupled coils, which types of device could be substituted for L2, in a closed magnetic circuit.

As set forth above, both the series and shunt VHF matching embodiments include matching circuitry which operate to effectively match the impedance of a motor vehicle electrically heatable window heating element to an aerial input impedance of an aerial feeder circuit of a radio receiver, to thereby effect efficient VHF signal reception. The VHF band amplifier of each of these embodiments also has a matching function as described hereinabove. The VHF amplifying transistor is chosen for its low noise factor and the matching circuit is designed to present a source impedance to this device which is as close as possible to its optimum low-noise source impedance.

It will be noted that for the sake of clarity in understanding the similarities and differences of the shunt matching and series matching embodiments, functionally equivalent components of the same have been designated like component enumerations in Figures 4 and 2, respectively.

With further regard to Figure 4, the following is provided to set forth component value designations and descriptions, as designed for the depicted embodiment:—

L1 4+4 turns, 9.5 mm diameter, 1.6 mm wire;
L2 10-1/2+10-1/2 turns in 30 mm ferrite pot core, 1.4 mm wire, 1.2—1.4 mH;
L4 4+4 turns, 0.5 mm wire, 6 mm diameter;
L5 8 turns-resonant at 98 mHz in circuit;
L6 16 turns-self-resonant at 98 mHz in circuit;
L8 1 mH choke inductor.

The above values are specific for a particular model.

The hereinabove set forth embodiments for series matching and shunt matching and, in particular, their respective matching circuit arrangements, could, in princpile, be used to couple a window heater antenna to a VHF transmitter/receiver unit, provided that the required overall bandwidth is not excessive. However, it should be recognised that satisfactory/efficient operation of a VHF transmitter may normally demand a better quality of match than that which may be acceptable for a receiver. Thus, depending on the natural resonance of the heater antenna (and its connecting leads to the matching circuit) at the frequency band of interest, and on the separation of the VHF transmit and receive frequencies, it may prove difficult to achieve satisfactory and efficient performance if a matching device or circuitry having a single passband is employed. The hereinbefore set forth series matching embodiment may be used for a window element that is naturally series-resonant and the disclosed shunt matching embodiment may be used with window elements which are naturally shunt-resonant over the VHF band. In both cases, the embodiments have been designed for a broad-band VHF reception of approximately 88—108 MHz, and an AM broadcast band of 0.15—1.6 MHz.

With respect to the possible difficulty in achieving satisfactory/efficient performance of matching circuitry having a single passband, a third embodiment of the invention is provided in Figure 5 which depicts a split passband matching embodiment.

Referring to Figure 5, the depicted embodiment provides an isolating and matching device having two passbands which may be designed to give improved performance in the neighbourhood of relatively widely separated transmit and receive frequencies, i.e. 82 and 98 MHz, as in the present example. In this embodiment, an isolating circuit means L1, which comprises an air-cored bifilar inductor device, provides a path for the window heater supplied power from a motor vehicle d.c. power supply or demister power supply means, and such isolating circuit means is also designed to bring the heating element of the window heater to parallel resonance near the centre of the VHF band. Such bifilar arrangement may also be designed to bring the heating element to parallel resonance near the centre or mean frequency of two predetermined transmit and receive frequencies.

Capacitor C1, together with lead and stray inductance, forms a series resonator means at such centre frequency, as does a second series resonator means comprising L3—C2. The effect of the parallel resonance mentioned above, acting with the latter mentioned series resonance characteristic, is designed to provide and produce a parallel resonant characteristic in the region of a transmit frequency and also in the region of a receive frequency, which frequencies may be predetermined. Circuits L4—C3 and L5—C4, which are connected in parallel with each other and connected between the second series resonator means L3—C2 and an aerial terminal (not shown) for connection to an aerial feeder circuit of a transmit/receive unit, provide a series resonant characteristic at each of two frequencies, one for transmission and the other for reception. The transmit/receive unit may be a two-way VHF communications transceiver device and, with further regard to circuits L4—C3 and L5—C4, one is designed to be series resonant at a predetermined VHF transmit frequency and the other is designed to be series resonant at a predetermined VHF receive frequency. For example, L4—C3 may be designed to be series resonant at 82 MHz for transmit, and L5—C4 may be designed to be series resonant at 98 MHz for receive, as in the present example. The overall characteristic of this circuit embodiment may be designed to give near-optimum matching over two passbands, one centred on a predetermined transmit frequency and the other centred on a predetermined receive frequency.

The Split Passband Matching embodiment thus provides an isolating and matching device which is designed to be operable to provide near-optimum matching over two VHF passbands, one for transmission of VHF signals and the other for reception of VHF signals; and, depending on the component and element values which arise when a scheme of this type is applied or designed for a particular window heater-antenna structure, it may be desirable to introduce impedance transformations and other circuit modifications.

It is of course to be understood that the invention is not intended to be restricted to the details of the above embodiments which are described by way of example only.

Thus, for example, AM performance can be improved by exploiting the existing voltage follower stage shown in Figure 2.

The input impedance to this stage is high, largely governed in this case by the 10K input bias resistor (R4 in Figure 2). The AM output at the bifilar coil can therefore be stepped up without severe loading by the emitter follower input.

As shown in Figure 6, an extra coil is wound on the bifilar winding to produce an auto transformer effect stepping up the AM voltage presented to the base of the emitter follower. This extra coil is of fine wire (around 0.15 mm). The number of turns may vary depending upon the specific circumstances but step up ratios 1:1.5 to 1:2.5 can be considered. An extra coil of 9.5 turns will produce a ratio of 1.2 giving a theoretical improvement in signal of about 6 dB.

Moreover, although Figure 2 shows an emitter follower AM amplifier with a series-matched embodiment and Figure 4 shows an AM source follower with a shunt-matched embodiment it is to be understood that the opposite arrangements could also be used (e.g. an AM source follower with a series VHF matching circuit.

Yet further, references to AM and FM as used herein are to be construed as convenient references to frequency ranges i.e. respectively low/medium frequencies and VHF frequencies. No restriction is necessarily intended on the modulation method used.

With the above described embodiments, in each case it will be understood that an efficient VHF aerial is achieved using a conventional heated window. No physical modification is required. The adaptation for VHF purposes is achieved electronically using the isolating and matching circuitry which is connected to the usual input leads of the heating element and can be mounted at any suitable position alongside the window.

**Claims**

1. An isolating and matching device to enable a heating element of a motor vehicle electrically heatable window, not designed specifically to be an aerial to be used as a receiving aerial in a band within the VHF range, said device having input leads for connection to a motor vehicle d.c. power supply, output leads for connection to said heating element, an aerial terminal for connection to an aerial feeder circuit of a receiver, isolating circuitry (L1, L2) coupled with said input and output leads and operable to permit passage of d.c. power from said input leads to said output leads while isolating or blocking passage of RF signals from said output leads to said input leads, and aerial matching circuitry interposed between said output leads and said aerial terminal characterised in that said matching circuitry has components (L1, L3, C5; L1, Ca; L1, C1, L3, C2) arranged to be connected to said heating element so as to define therewith a circuit which is resonant near the centre of a band within the VHF range, and which is operable to effectively match the impedance of said resonant circuit to an input impedance of the aerial feeder.

2. A device according to Claim 1, characterised in that said components (L1, L3, C5) are operable to bring the said heating element to series resonance near the centre of the VHF band.

3. A device according to Claim 1, characterised in that said components (L1, Ca) incorporate an inductance (L1) of the said isolating circuitry and are operable to bring the said heating element to parallel resonance near the centre of the VHF band.

4. A device according to Claim 2 or 3, characterised in that said matching circuitry includes a parallel resonant circuit (L4, C7, C6).

5. A device according to any one of Claims 2 to 4, characterised in that said isolating circuitry (L1, L2) includes at least one bifilar coil.

6. A device according to any one of Claims 2 to 4, characterised in that said isolating circuitry (L1, L2) includes a toroidal or U-shaped core wound with two mutually coupled coils.

7. A device according to Claim 4, characterised in that a VHF band amplifier (TR2) is connected with said parallel resonant circuit (L4, C7, C6).

8. A device according to Claim 7, characterised in that an AM band amplifier (TR3) is also provided to afford reception of AM signals by said receiver.

9. A device according to Claim 8, characterised in that a bias-supply circuit (D1, TR1, R3, R5) is provided for said VHF band and AM band amplifiers.

10. A device according to Claim 1 for use in conjunction with a VHF transmitter as well as a receiver, characterised in that said matching circuitry comprises a circuit for providing two VHF passbands (L4, C3; L5, C4), one centred on a predetermined VHF transmit frequency and the other centred on a predetermined VHF receive frequency.

11. A device according to Claim 10, characterised in that an inductor (L1) of said isolating circuit is used to bring the said heating element to parallel resonance near the centre of the VHF band.

12. A device according to Claim 10 or 11, characterised in that said matching circuitry comprises a first series resonator (C1), and a second series resonator (L3, C2), operable to produce series resonance near the centre of the VHF band.

13. A device according to Claim 12, characterised in that said matching circuitry comprises two series resonant circuits (L4, C3; L5, C4) for providing two VHF passbands respectively at a predetermined VHF transmit frequency and a predetermined VHF receive frequency.

14. A device according to Claim 13, characterised in that said two series resonant circuits (L4, C3; L5, C4) are connected in parallel with each other and connected between said second series resonator and said aerial terminal.

**Patentansprüche**

1. Trennungs- und Anpassungseinrichtung mit dem Zweck, ein nicht speziell als Antenne ausgelegtes Heizelement der beheizbaren Fensterscheibe eines Motorfahrzeuges als Empfangsantenne im VHF-(Meterwellen-)Bereich zu benutzen, wobei diese Einrichtung Eingangs-Anschlußleitungen zur Verbindung mit einer Fahrzeug-Gleichstromquelle und Ausgangs-Anschlußleitungen zur Verbindung mit dem Heizelement aufweist sowie einen Antennenanschluß zur Verbindung mit dem Antennenspeisekreis eines Empfängers, eine Trennschaltung (L1, L2), die mit den Eingangs- und Ausgangs-Anschlußleitungen gekoppelt und derart ausgelegt ist, daß sie von den Eingangs- zu den Ausgangs-Anschlußleitungen Gleichstrom durchläßt und Hochfrequenzsignale sperrt, sowie eine Antennen-Anpassungsschaltung, die zwischen den Eingangs-Anschlußleitungen und dem Antennenanschluß angeordnet ist, dadurch gekennzeichnet, daß die Anpassungsschaltung Schaltelemente (L1, L3, C5; L1, Ca; L1, C1, L3, C2) aufweist, die derart an das Heizelement angeschlossen sind, daß sie mit ihm einen Schwingkreis bilden, der eine Resonanzfrequenz nahe der Bandmitte eines im VHF-Bereich liegenden Frequenzbandes hat, und daß die Anpassungsschaltung zur effektiven Impedanzanpassung des Resonanzkreises an eine Eingangsimpedanz der Antenneneinspeisung ausgelegt ist.

2. Einrichtung nach Anspruch 1, dadurch gekennzeichnet, daß die Schaltelemente (L1, L3, L5) derart ausgelegt sind, daß sie das Heizelement in Serienresonanz nahe der Mitte des VHF-Bandes bringen.

3. Einrichtung nach Anspruch 1, dadurch gekennzeichnet, daß die Schaltelemente (L1, Ca) eine Induktivität der Trennschaltung enthalten und derart ausgelegt sind, daß sie das Heizelement in Parallelresonanz nahe der Mitte des VHF-Bandes bringen.

4. Einrichtung nach Anspruch 2 oder 3, dadurch gekennzeichnet, daß die Anpassungsschaltung einen Parallelresonanzkreis (L4, C7, C6) enthält.

5. Einrichtung nach einem der Ansprüche 2 bis 4, dadurch gekennzeichnet, daß die Trennschaltung (L1, L2) mindestens ee Bifilarwicklung enthält.

6. Einrichtung nach einem der Ansprüche 2 bis 4, dadurch gekennzeichnet, daß die Trennschaltung (L1, L2) einen Ringkern oder U-Kern enthält, der zwei gekoppelte Wicklungen aufweist.

7. Einrichtung nach Anspruch 4, dadurch gekennzeichnet, daß an den Parallelresonanzkreis (L4, C7, C6) ein VHF-Band-Verstärker (TR2) angeschlossen ist.

8. Einrichtung nach Anspruch 7, dadurch gekennzeichnet, daß ein Verstärker (TR3) für amplitudenmodulierte Frequenzen (AM-Verstärker) vorgesehen ist, um den Empfang von amplitudenmodulierten Signalen durch den Empfänger zu gewährleisten.

9. Einrichtung nach Anspruch 8, dadurch gekennzeichnet, daß für den VHF-Band-Verstärker und den AM-Verstärker ein Vorspannungs-Versorgungskreis (D1, TR1, R3, R5) vorgesehen ist.

10. Einrichtung nach Anspruch 1 zur Verwendung in Verbindung mit einem VHF-Sender und als Empfänger, dadurch gekennzeichnet, daß die Anpassungsschaltung einen Schaltkreis (L4, C3; L5; C4) zum Durchlaß von zwei VHF-Frequenzbändern enthält, von denen das eine mit seiner Mittenfrequenz auf einer vorgegebenen Sendefrequenz und das andere mit seiner Mittenfrequenz auf einer vorgegebenen Empfangsfrequenz liegt.

11. Einrichtung nach Anspruch 10, dadurch gekennzeichnet, daß eine Induktivität (L1) der Trennschaltung dazu verwendet ist, das Heizelement in Parallelresonanz nahe der Mittelfrequenz des VHF-Frquenzbandes zu bringen.

12. Einrichtung nach Anspruch 10 oder 11, dadurch gekennzeichnet, daß die Anpassungsschaltung ein erstes Serienresonanz-Element (C1) und einen zweiten Serienresonanzkreis (L3, C2) zur Erzeugung einer Serienresonanz nahe der Mittenfrequenz des VHF-Frequenzbandes enthält.

13. Einrichtung nach Anspruch 12, dadurch gekennzeichnet, daß die Anpassungsschaltung zwei Serienresonanzkreis (L4, C3; L5, C4) zur Erzeugung zweier Durchlaßbereiche für eine vorgebene VHF-Sendefrequenz bzw. eine vorgegebene VHF-Empfangsfrequenz aufweist.

14. Einrichtung nach Anspruch 13, dadurch gekennzeichnet, daß die beiden Serienresonanzkreis (L4, C3; L5, C4) parallel zueinander und zwischen den zweiten Serienresonanzkreis und den Antennenanschluß geschaltet sind.

## Revendications

1. Dispositif d'isolation et d'adaptation destiné à permettre à un élément de chauffage d'une glace électriquement chauffable d'un véhicule à moteur, qui n'est pas spécialement conçu pour constituer une antenne, d'être utilisé comme antenne de réception dans une plage dans la bande des ondes très courtes, ledit dispositif comportant des conducteurs d'entrée destinés à être connectés à la source d'alimentation en courant continu d'un véhicule à moteur, des conducteurs de sortie destinés à être connectés audit élément de chauffage, une borne d'antenne destinée à être connectée à un circuit d'alimentation d'antenne d'un récepteur, des éléments d'isolation (L1, L2) connectés auxdits conducteurs d'entrée et de sortie afin de fonctionner pour permettre le passage d'une énergie en courant continu desdits conducteurs d'entrée auxdits conducteurs de sortie tout en isolant ou bloquant le passage des signaux haute fréquence desdits conducteurs de sortie vers lesdits conducteurs d'entrée, et des éléments d'adaptation d'antenne interposés entre lesdits conducteurs de sortie et ladite borne d'antenne, caractérisé en ce que lesdits éléments d'adaptation comprennent des éléments (L1, L3, C5; L1, Ca; L1, C1, L3, C2) agencés pour être connectés audit élément de chauffage afin de définir avec celui-ci un circuit qui est résonant à proximité du centre d'une plage dans la bande des ondes très courtes, et qui peut fonctionner pour adapter de façon efficace, l'impédance dudit circuit résonnant à une impédance d'entrée du circuit d'alimentation de l'antenne.

2. Dispositif suivant la revendication 1, caractérisé en ce que lesdits éléments (L1, L3, C5) peuvent fonctionner afin d'amener l'élément de chauffage à une résonance série à proximité du centre de la bande des ondes très courtes.

3. Dispositif suivant la revendication 1, caractérisé en ce que les éléments (L1, Ca) incorporent une inductance (L1) dudit élément d'isolation et peuvent fonctionner pour amener l'élément de chauffage à une résonance parallèle à proximité du centre de la bande des ondes très courtes.

4. Dispositif suivant la revendication 2 ou 3, caractérisé en ce que lesdits éléments d'adaptation comprennent un circuit de résonance parallèle (L4, C7, C6).

5. Dispositif suivant l'une quelconque des revendications 2 à 4, caractérisé en ce que lesdits éléments d'isolation (L1, L2) comprennent ou moins une bobine à roulement bifilaire.

6. Dispositif suivant l'une quelconque des revendications 2 à 4, caractérisé en ce que lesdits éléments d'isolation (L1, L2) comprennent un noyau toroïdale ou formé en U enroulé avec deux bobines interconnectées.

7. Dispositif suivant la revendication 4, caractérisé en ce qu'un amplificateur de la bande des ondes très courtes (TR2) est connecté audit circuit de résonance parallèle (L4, C7, C6).

8. Dispositif suivant la revendication 7, caractérisé en ce qu'un amplificateur de la bande de modulation d'amplitude (TR3) est également prévu afin de permettre la réception de signaux MA par ledit récepteur.

9. Dispositif suivant la revendication 8, caractérisé en ce qu'un circuit d'alimentation de polarisation (D1, TR1, R3, R5) est prévu pour lesdits amplificateurs de la bande des ondes très courtes et de la bande de modulation d'amplitude.

10. Dispositif suivant la revendication 1, destiné à être utilisé en combinaison avec un transmetteur d'ondes très courtes ainsi qu'avec un récepteur, caractérisé en ce que lesdits éléments d'adaptation comprennent un circuit destiné à fournir deux bandes passantes pour des ondes très courtes (L4, C3; L5, C4), l'une étant centrée sur une fréquence prédéterminée de transmission d'ondes très courtes et l'autre étant centrée sur une fréquence prédéterminée de réception d'ondes très courtes.

11. Dispositif suivant la revendication 10, caractérisé en ce qu'une inductance (L1) dudit circuit d'isolation est utilisée afin d'amener l'élément de chauffage à une résonance parallèle à proximité du centre de la bande des ondes très courtes.

12. Dispositif suivant la revendication 10, caractérisé en ce que lesdits éléments d'adaptation comprennent un premier résonateur série (C1) et un second résonateur série (L3, C2) pouvant fonctionner pour produire une résonance série à proximité du centre de la bande des ondes très courtes.

13. Dispositif suivant la revendication 12, caractérisé en ce que lesdits éléments d'adaptation comprennent deux circuits de résonance série (L4, C3; L5, C4) destinés à fournir chacun deux bandes passantes d'ondes très courtes à une fréquence prédéterminée de transmission d'ondes très courtes et à une fréquence prédéterminée de réception d'ondes très courtes.

14. Dispositif suivant la revendication 13, caractérisé en ce que deux circuits de résonance série (L4, C3; L5, C4) sont connectées en parallèle l'un avec l'autre et connectés entre ledit second résonateur série et ladite borne d'antenne.

FIG.1

FIG.3

FIG.5

Fig. 2

Fig. 6

EP 0 146 339 B1

_FIG.4_

EP 0 146 339 B1